(19) Europäisches Patentamt

European Patent Office

Office européen des brevets

(11) EP 0 855 793 A2

## EUROPEAN PATENT APPLICATION

(12)

(43) Date of publication:
29.07.1998 Bulletin 1998/31

(51) Int. Cl.$^6$: H03G 7/00

(21) Application number: 98100842.8

(22) Date of filing: 19.01.1998

(84) Designated Contracting States:
AT BE CH DE DK ES FI FR GB GR IE IT LI LU MC NL PT SE
Designated Extension States:
AL LT LV MK RO SI

(30) Priority: 22.01.1997 JP 9286/97

(71) Applicant:
Alpine Electronics, Inc.
Tokyo 141 (JP)

(72) Inventor: Sekine, Koji
Iwaki-City, Fukushima (JP)

(74) Representative:
Klunker . Schmitt-Nilson . Hirsch
Winzererstrasse 106
80797 München (DE)

(54) **Method of controlling dynamic range of digital audio broadcasting receiver**

(57) A method of controlling a dynamic range control level according to a user's choice or the level of noise. A table containing dynamic range control data (DRC data) and dynamic range control levels (DRC levels) correlated to each other is stored in a memory of an audio decoding unit, and level control data items $\alpha_L$, $\alpha_M$ and $\alpha_H$ for changing each DRC level are stored in a data memory. One of the level control data items $\alpha_L$, $\alpha_M$ and $\alpha_H$ to be used is designated by operating an operating section or automatically determined on the basis of the level of external noise. The audio decoding unit obtains the DRC level corresponding to DRC data added to audio data from the correlation table. A DRC level adjustment unit adjusts the DRC level by using the designated one of the level control data items $\alpha_L$, $\alpha_M$ and $\alpha_H$. The audio decoding unit controls the dynamic range of an audio signal on the basis of the adjusted DRC level.

FIG. 1

EP 0 855 793 A2

## Description

BACKGROUND OF THE INVENTION

1. Field of the Invention

The present invention relates to a method of controlling a dynamic range of a digital audio broadcasting receiver and, more particularly to a method of controlling a dynamic range of a digital audio broadcasting receiver in which the dynamic range of an audio signal is controlled on the basis of dynamic range control data added to audio data contained in a digital audio broadcasting signal.

2. Description of the Related Art

Excellent characteristics of digital audios have generally been recognized and applications of digital audios are now being rapidly increased. On this background, digitization of audio broadcasting is being promoted and practical digital audio broadcasting (DAB) is being realized in Europe.

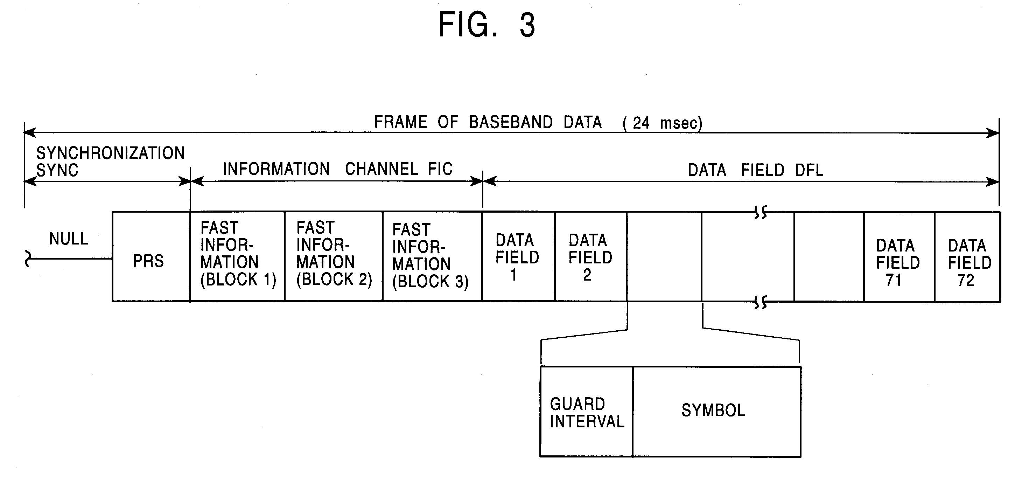

Fig. 3 shows a mode II frame structure for use in a DAB system. The length of one frame is 24 ms and one frame is formed of a 2-symbol synchronization section SYNC, a 3-symbol fast information channel section FIC, and a 72-symbol data field section DFL. The synchronization section SYNC contains a null symbol and a phase reference symbol PRS used for recognition of the start point of the frame. In the fast information channel FIC, information indicating time/date data, service (program) arrangement data, service names (labels) service identification codes SId, program types PTY and the like are inserted and a cyclic redundancy check is added to the end of this information. The data field section DFL is divided into 72 data fields, and audio data of a predetermined service is inserted in each data field, so that audio data of 6 to 8 services can be simultaneously transmitted from one broadcasting station. The corresponding relationship between the data fields and services is designated with service arrangement data contained in the fast information channel section FIC. A mode II frame structure for satellite broadcasting using a frequency band of 50 MHz to 250 MHz has been described with reference to Fig. 3. A mode I frame structure used with a frequency band of 50 to 250 MHz is substantially the same as the above-described frame structure and has a frame length of 96 ms.

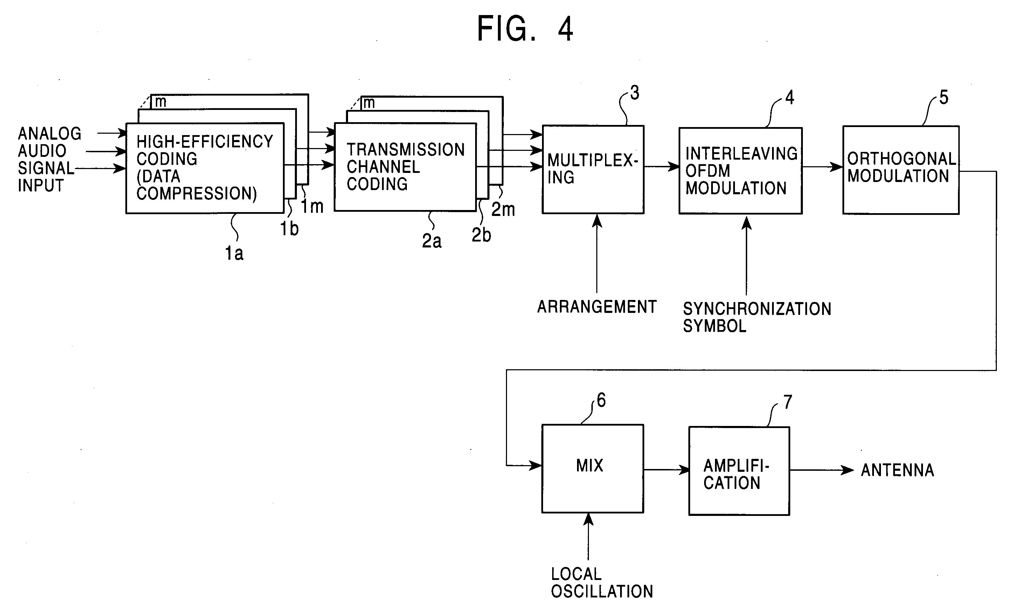

Fig. 4 shows the configuration of a DAB transmitter. Data compression sections 1a to 1m respectively encode analog signals (audio signals of services) into MPEG audio signals at a high efficiency. Transmission channel coding sections 2a to 2m add an error detection and correction code to the signals. A multiplexing section 3 time-division multiplexes groups of data output from the transmission channel coding sections 2a to 2m in accordance with service arrangement data by mapping the data to predetermined data fields (symbols). An interleaving/OFDM modulation section 4 performs orthogonal frequency division multiplex (OFDM) modulation by inverse discrete Fourier transform (IDFT) and performs interleaving by rearranging the order of the multiplex signals in the symbols in accordance with a predetermined format. That is, the ORDM modulation section differentially encodes each of symbols (phase reference symbol, data symbol) by dividing the symbol into N pairs of bits and by setting the first data in each group as a real part and the second data as an imaginary part, and performs IDFT processing by successively outputting the real and imaginary parts in the differential code to an inverse Fourier transform section. Base band modulated waves are thereby output.

An orthogonal modulation section 5 performs orthogonal transform by converting the real and imaginary parts output from the interleaving/OFDM modulation section into analog signals, by multiplying the analog signals respectively by cosine and sine waves of a transmission local frequency fc, and by combining the multiplication results. A frequency conversion section 6 converts the transmission carrier waves obtained by orthogonal modulation into RF signals. A transmission power amplifier 7 amplifies the RF signals.

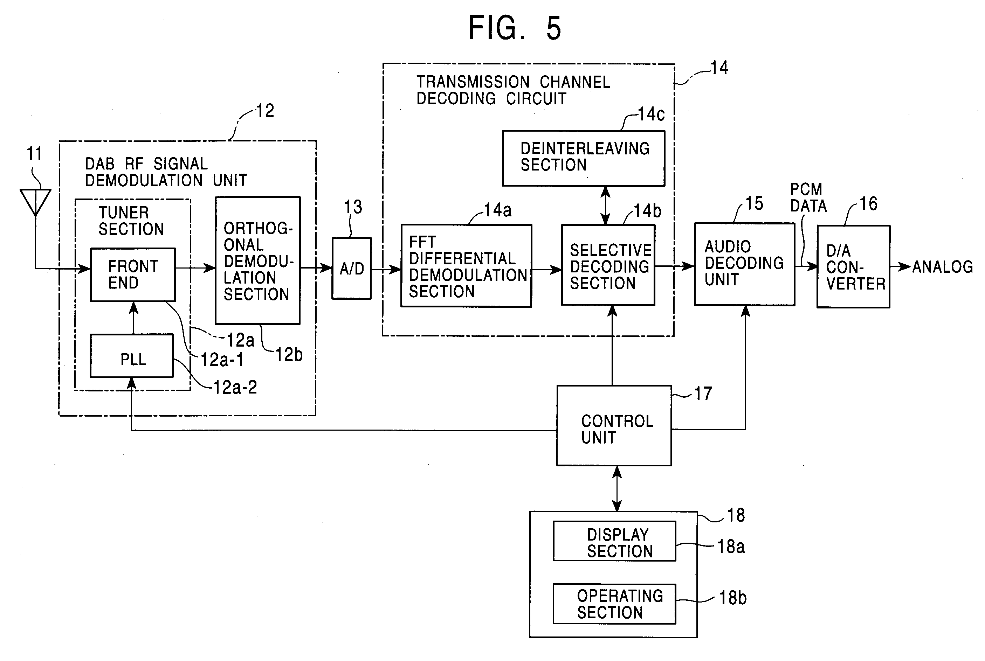

Fig. 5 shows the configuration of a DAB receiver. A DAB RF signal demodulation unit 12 receives desired DAB broadcasting waves through an antenna 11 and outputs a baseband analog signal by multiplying the received signal by cosine and sine waves of the carrier frequency fc. An analog-to-digital (A/D) converter 13 converts the baseband analog signal into a digital signal at a predetermined sampling frequency. A transmission channel decoding circuit 14 performs fast Fourier transform (FFT) demodulation processing, differential decoding processing and so on to restore and output high-efficiency code data (MPEG audio data). An audio decoding unit 15 decodes the MPEG audio data into the original PCM audio data. A digital-to-analog (D/A) converter 16 converts the PCM audio data into an analog audio signal. A control unit 17 performs overall control of the receiver. An operation/display unit 18 has a display section 18a and an operating section 18b.

The DAB RF signal demodulation unit 12 has a tuner section 12a and an orthogonal demodulation section 12b. The tuner section 12a receives DAB signal waves and converts them into an intermediate frequency signal. The tuner section 12a is formed of a front end 12a-1 having a tuning section, a high-frequency amplifier and a frequency converter, and a phase locked loop circuit (local oscillation circuit) 12a-2 for outputting a frequency signal according to a tuned frequency. The orthogonal demodulation section 12b outputs a baseband analog signal by multiplying the received signal by cosine and sine waves of the carrier frequency fc.

The transmission channel decoding circuit 14 has an FFT differential demodulation section 14a, a selective decoding section 14b and a deinterleaving section 14c. The FFT differential demodulation section 14a processes the digital data output from the A/D converter 13 by FFT processing and differential coding processing, thereby recovering the interleaved transmitted data. The deinterleaving section 14c deinverleaves the data output from the FFT differential demodulation section to restore the original data series. The selective decoding section 14b processes the deinterleaved data by error detection and correction processing and inputs the content of the fast information channel section FIC to the control unit 17. The control unit 17 detects the symbol position of a service (program) designated by a user on the basis of service arrangement data contained in the fast information channel section FIC, and informs the selective decoding section 14b of the detection result. The selective decoding section 14b obtains decoded data of the symbol (data field) designated by this information and outputs the decoded data to the audio decoding section 15. The audio decoding section 15 decodes the input MPEG audio data into the original PCM audio data and outputs the PCM audio data. The control unit 17 sends a label (program name) contained in the fast information channel FIC to the operation/display unit to display it according to a user's need.

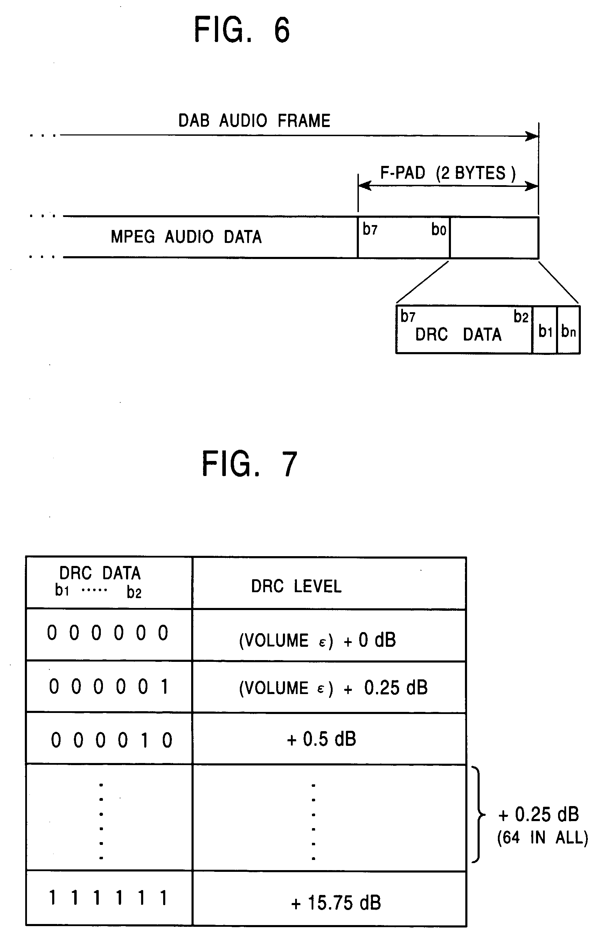

Two bytes of data called F-PAD are added to the end of MPEG audio data, as shown in Fig. 6. Six bits $b_1$ to $b_7$ in the added two bytes designate dynamic range control (DRC) data.

In the environment inside a vehicle cabin or the like or other environments under the influence of various noises, it is difficult to perceive sound at a low sound pressure level. Dynamic range control (DRC) is a technique of increasing the sound pressure level of a soft sound, which is liable to be masked with noise or the like, so that the sound is naturally audible in such an unfavorable environment. The audio decoding section 15 ① has DRC levels previously stored while being correlated to DRC data as shown in Fig. 7, ② decodes the MPEG audio data and DRC data, ③ obtains the DRC level corresponding to the DRC data from the correlation table, and ④ increases the sound pressure level of the MPEG audio data by the DRC level, thereafter outputting the audio data. Thus, DRC data is added to the audio data in order that the DRC level for a portion of audio data corresponding to a low pressure level of sound be increased, thereby enabling a user to hear the sound of the low sound pressure level even in a noisy environment.

The conventional DRC control is performed in accordance with one correlation table (Fig. 7). Therefore, there is a possibility of failure to perform DRC control in accordance with a user's preference. Moreover, in a vehicle cabin or the like, where the influence of various noises is considerable, the conventional DRC control is not satisfactory in the performance of making a sound naturally audible. In particular, since the level of noise in a vehicle cabin or the like varies largely with time, there is a possibility of failure to make a soft sound audible if the level of noise is high.

SUMMARY OF THE INVENTION

In view of the above-described circumstances, an object of the present invention is to provide a method of dynamic range control (DRC) in which a DRC level can be changed according to a user's choice.

Another object of the present invention is to provide a method of dynamic range control (DRC) in which a DRC level is determined according to a noise level.

To achieve the above-described objects, according to the present invention, there is provided a method of controlling a dynamic range of a digital audio broadcasting receiver, comprising the steps of storing dynamic range control levels (DRC levels) correlated to the dynamic range control data (DRC data) and storing a plurality of level control data items for adjusting each DRC level, designating one of the level control data items to be used, adjusting the DRC level corresponding to certain DRC data by using the designated level control data item, and controlling the dynamic range of an audio signal on the basis of the adjusted dynamic range control level. The DRC level is made variable according to a user's choice, thereby enabling the user to naturally hear the sound in accordance with the user's preference.

Also, according to the present invention, level control data may be determined on the basis of the level of external noise. The DRC level is increased if external noise is louder, thereby enabling to naturally hear even a soft sound.

BRIEF DECRIPTION OF THE DRAWINGS

Fig. 1 is a diagram showing the configuration of a first DAB receiver to which the method of the present invention is applied;

Fig. 2 is a diagram showing the configuration of a second DAB receiver to which the method of the present invention is applied;

Fig. 3 is a diagram showing the structure of a DAB frame;

Fig. 4 is a diagram showing the configuration of a DAB transmitter;

Fig. 5 is a diagram showing the configuration of a conventional DAB receiver;

Fig. 6 is a diagram of dynamic range control data (DRC data); and

Fig. 7 is a DRC data-DRC level correlation table.

DESCRIPTION OF THE PREFERRED EMBODIMENTS

(A) First Embodiment of the Invention

(a) Configuration

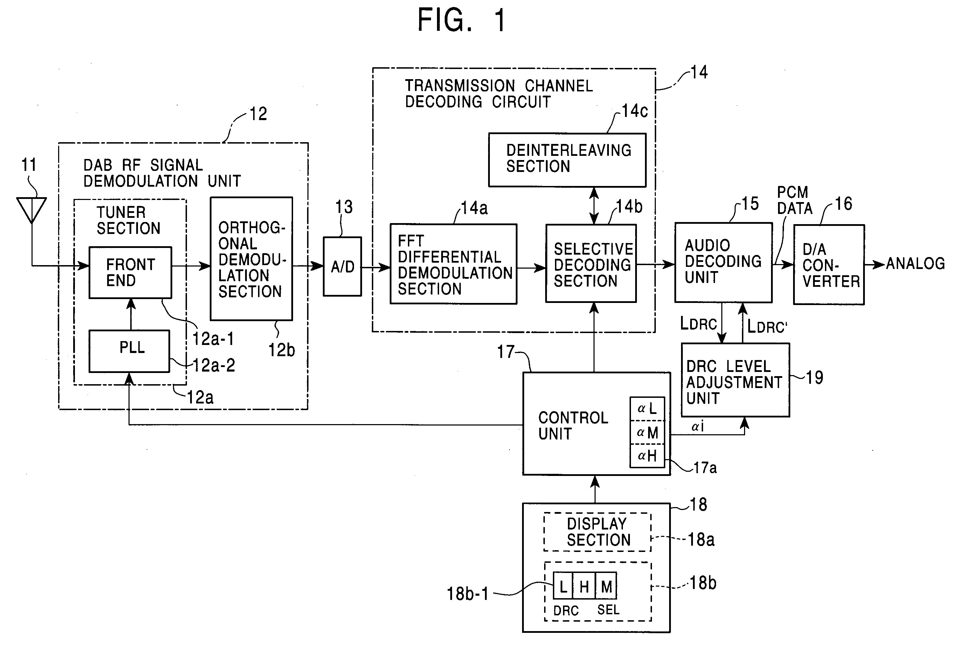

Fig. 1 shows the configuration of a first embodiment of a DAB receiver to which the method of the present invention is applied. In Fig. 1, the components identical or corresponding to those in the conventional arrangement shown in Fig. 5 are indicated by the same reference characters.

The DAB receiver has an antenna 11, a DAB RF signal demodulation unit 12, an A/D converter 13, a transmission channel decoding circuit 14, an audio decoding unit 15 for decoding MPEG audio data into original PCM audio data, a D/A converter 16, a control unit 17 for overall control of the receiver, an operation/display unit 18 and a DRC level adjustment unit 19.

The DRC level adjustment unit 19 adjusts a dynamic range control level (DRC) level by using level control data $\alpha i$ ($\alpha_L$, $\alpha_M$, $\alpha_H$) designated by a user. For example, if the DRC level corresponding to DRC data added to audio data is $L_{DRC}$, the DRC level adjustment unit 19 adjusts the DRC level as shown by the following equation:

$$L_{DRC}' = \alpha i \cdot L_{DRC} \qquad (1)$$

The audio decoding unit 15 ① has a DRC data-DRC level correlation table, such as that shown in Fig. 7, stored in a memory (not shown), ② recovers the MPEG audio data and DRC data supplied from the selective decoding section 14b, ③ obtains the DRC level $L_{DRC}$ corresponding to the recovered DRC data and inputs the DRC level $L_{DRC}$ to the DRC level adjustment unit 19, and ④ outputs the MPEG audio data while controlling the sound pressure level of the MPEG audio data on the basis of the DRC level $L_{DRC}'$ adjusted by the DRC level adjustment unit 19. The sound pressure level control is performed by adding the adjusted DRC level $L_{DRC}'$ to the sound pressure level of the audio data.

The control unit 17 has a microcomputer configuration and has a processor CPU, a program memory (ROM) and a data memory (RAM) 17a. In the data memory 17a, level control data items $\alpha_L$, $\alpha_M$ and $\alpha_H$ for controlling the DRC level are previously stored. Data item $\alpha_L$ is a low-level control value, e.g., a value smaller than 1 for converting each of the DRC levels shown in the correlation table of Fig. 7 into a lower level. Data item $\alpha_L$ is used in a low-noise environment. Data item $\alpha_M$ is a mid-level control value, e.g., 1. Each DRC level shown in the correlation table of Fig. 7 is not changed thereby. Data item $\alpha_M$ is used in a medium-noise environment. Data item $\alpha_H$ is a high-level control value, e.g., a value larger than 1 for converting each DRC level shown in the correlation table of Fig. 7 into a higher level. Data item $\alpha_H$ is used in a high-noise environment.

The operating section 18b of the operation/display unit 18 has various keys, including, as keys pertaining to the present invention, selection keys 18b-1 for selecting one of the level control data values $\alpha_L$, $\alpha_M$ and $\alpha_H$.

(b) Operation

One of the selection keys 18b-1 of the operating section 18b is previously operated to select the predetermined level control data $\alpha i$ (i = L, M, H) from the level control data items $\alpha_L$, $\alpha_M$ and $\alpha_H$. The selected data is input to the control unit 17.

When the audio decoding unit 15 is thereafter supplied with decoded data from the selective decoding section 14 of the transmission channel decoding circuit 14, it recovers MPEG audio data and DRC data by using this decoded data, obtains the DRC level $L_{DRC}$ corresponding to the recovered DRC data from the correlation table, and inputs the DRC level $L_{DRC}$ to the DRC level adjustment unit 19.

The DRC level adjustment unit 19 adjusts the DRC level in accordance with equation (1) by using the level control data $\alpha i$ ($\alpha_L$, $\alpha_M$, $\alpha_H$) designated by a user and inputs the adjusted value $L_{DRC}'$ to the audio decoding unit 15. The audio decoding unit 15 increases the sound pressure level of the MPEG audio data by the amount equal to this adjusted DRC level $L_{DRC}'$ and inputs the increased sound pressure level to the subsequent D/A converter 16.

Subsequently, the same control is performed to increase the level of MPEG audio data by the amount equal to the DRC level $L_{DRC}'$ adjusted by the level control data $\alpha i$ ($\alpha_L$, $\alpha_M$, $\alpha_H$) designated by the user. As a result, dynamic range control can be performed according to a user's preference or to a noise environment, thereby enabling the user to naturally hear the sound.

The embodiment has been described with respect to the case where three values $\alpha_L$, $\alpha_M$ and $\alpha_H$ are provided as level control data. However, if four or more values are provided as level control data, finer dynamic range control can be performed.

(B) Second Embodiment of the Invention

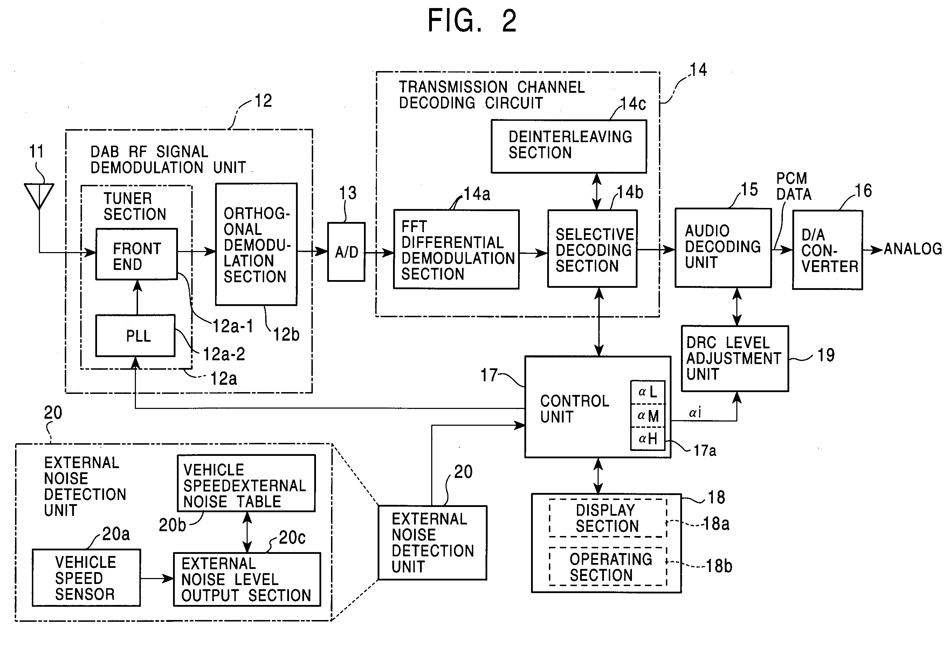

Fig. 2 shows the configuration of a second embodiment of the DAB receiver to which the method of the present invention is applied. In Fig. 2, the components identical or corresponding to those in the first embodiment shown in Fig. 1 are indicated by the same reference characters. The second embodiment differs from the first embodiment in that level control data items $\alpha_L$, $\alpha_M$ and $\alpha_H$ are not set by a user but automatically determined according to the level of external noise.

Referring to Fig. 2, an external noise detection unit 20 is provided. A complicated circuit configuration is required to detect external noise other than audio sound. In the second embodiment, therefore, the level of external noise is presumably determined from the vehicle speed instead of being directly detected. This is because external noise other than audio sound tends to become louder if the vehicle speed becomes higher. Accordingly, the external noise detection unit 20 is provided with a vehicle speed sensor 20a, a vehicle speed-external noise level correlation table 20b for storing the correlation between the vehicle speed and the external noise level, and an external noise level output section 20c for obtaining the external noise level according to the vehicle speed from the correlation table and for inputting the obtained noise level to the control unit 17.

The control unit 17 determines level control data $\alpha i$ according to the external noise level and inputs the data to the DRC level adjustment unit 19. That is, the control unit 17 ① inputs level control data $\alpha_H$ to the DRC level adjustment unit 19 if external noise is loud, ② inputs level control data $\alpha_M$ to the DRC level adjustment unit 19 if external noise is medium, and ③ inputs level control data $\alpha_L$ to the DRC level adjustment unit 19 if external noise is little.

Once level control data $\alpha i$ ($\alpha_L$, $\alpha_M$, $\alpha_H$) is determined according to external noise as described above, dynamic range control is performed in the same manner as that in the first embodiment.

In the second embodiment, the DRC level is increased if external noise is louder, thus making even a soft sound naturally audible by a user.

The present invention has been described with respect to what are presently considered to be the preferred embodiments. However, other various modifications and changes of the invention can be made without departing from the spirit and scope of the invention set forth in the appended claims.

According to the present invention, as described above, dynamic range control levels are stored while being correlated to dynamic range control data; a plurality of level control data items for adjusting each dynamic range control level are stored; one of the level control data items to be used is designated; each dynamic range control level (DRC level) is adjusted by using the designated level control data; and the dynamic range of an audio signal is controlled on the basis of the adjusted DRC level. Therefore, each DRC level can be adjusted according to a user's choice, thereby enabling adjustment in accordance with the user's preference.

Also, according to the present invention, level control data is determined on the basis of the level of external noise. Therefore, a user can naturally hear sounds even if the noise environment changes with time.

**Claims**

1. A method of controlling a dynamic range of a digital audio broadcasting receiver on the basis of dynamic range control data added to audio data contained in a digital audio broadcasting signal, said method comprising the steps of:

storing dynamic range control levels correlated to dynamic range control data and storing a plurality of level control data items for adjusting each of the dynamic range control levels;

designating one of the level control data items to be used;

adjusting the dynamic range control level corresponding to the dynamic range control data added to the audio data by using the designated level control data item; and

controlling the dynamic range of an audio signal on the basis of the adjusted dynamic range control level.

2. A method according to Claim 1, wherein said level control data designation step is performed on the basis of the level of external noise.

3. A method according to Claim 2, wherein the level of external noise is obtained with respect to the speed of a vehicle.

4. A digital audio broadcasting receiver in which a dynamic range is controlled on the basis of dynamic range control data added to audio data contained in a digital audio broadcasting signal, said receiver comprising:

a storage for storing dynamic range control levels correlated to dynamic range control data and storing a plurality of level control data items for adjusting each of the dynamic range control levels;

a level control data designation section for designating one of the level control data items to be used;

a dynamic range control level adjustment section for adjusting the dynamic range control level corresponding to the dynamic range control data added to the audio data by using the level control data item designated by said level control data designation section; and

a dynamic range control section for controlling the dynamic range of an audio signal on the basis of the dynamic range control level adjusted by said adjustment section.

5. A digital audio broadcasting receiver according to Claim 4, further comprising:

an antenna;

a receiving unit for receiving the digital audio broadcasting signal containing the dynamic range control data, the digital audio broadcasting signal being input via said antenna;

an orthogonal demodulation unit for demodulating a signal output from said receiving unit by orthogonal demodulation; and

a transmission channel decoding unit for performing transmission channel decoding of a signal obtained as a demodulation result by said orthogonal demodulation unit.

6. A digital audio broadcasting receiver according to Claim 5, wherein said dynamic range control unit demodulates the audio data and the dynamic range control data from the data decoded by said transmission channel decoding unit.

7. A digital audio broadcasting receiver according to Claim 4, further comprising an external noise detection unit for detecting external noise, said level control data designation being performed according to the level of noise detected by said external noise detection unit.

8. A digital audio broadcasting receiver according to Claim 7, wherein said external noise detection unit has a vehicle speed sensor and outputs an external noise level corresponding to the speed of a vehicle from said vehicle speed sensor.

# FIG. 1

EP 0 855 793 A2

## FIG. 2

EP 0 855 793 A2

# FIG. 3

FRAME OF BASEBAND DATA ( 24 msec)

SYNCHRONIZATION SYNC

INFORMATION CHANNEL FIC

DATA FIELD DFL

NULL

PRS

FAST INFOR-MATION (BLOCK 1)

FAST INFOR-MATION (BLOCK 2)

FAST INFOR-MATION (BLOCK 3)

DATA FIELD 1

DATA FIELD 2

DATA FIELD 71

DATA FIELD 72

GUARD INTERVAL

SYMBOL

EP 0 855 793 A2

## FIG. 4

ANALOG AUDIO SIGNAL INPUT → HIGH-EFFICIENCY CODING (DATA COMPRESSION) [m, 1b, 1m, 1a] → TRANSMISSION CHANNEL CODING [m, 2b, 2m, 2a] → MULTIPLEX-ING (3) → INTERLEAVING OFDM MODULATION (4) → ORTHOGONAL MODULATION (5)

ARRANGEMENT (into MULTIPLEXING)

SYNCHRONIZATION SYMBOL (into INTERLEAVING OFDM MODULATION)

MIX (6) → AMPLIFI-CATION (7) → ANTENNA

LOCAL OSCILLATION (into MIX)

EP 0 855 793 A2

# FIG. 5

DAB RF SIGNAL DEMODULATION UNIT — 12

TUNER SECTION

FRONT END

PLL — 12a-2

12a

12a-1

ORTHOG-ONAL DEMODU-LATION SECTION — 12b

A/D — 13

TRANSMISSION CHANNEL DECODING CIRCUIT — 14

DEINTERLEAVING SECTION — 14c

FFT DIFFERENTIAL DEMODULATION SECTION — 14a

SELECTIVE DECODING SECTION — 14b

AUDIO DECODING UNIT — 15

PCM DATA

D/A CON-VERTER — 16

ANALOG

CONTROL UNIT — 17

DISPLAY SECTION — 18a

OPERATING SECTION — 18b

18

11

EP 0 855 793 A2

# FIG. 6

DAB AUDIO FRAME

F-PAD (2 BYTES )

| MPEG AUDIO DATA | b7    b0 | |
|---|---|---|

| b7    DRC   DATA    b2 | b1 | bn |

# FIG. 7

| DRC DATA $b_1$ ····· $b_2$ | DRC LEVEL |
|---|---|
| 0 0 0 0 0 0 | (VOLUME $\varepsilon$) + 0 dB |
| 0 0 0 0 0 1 | (VOLUME $\varepsilon$) + 0.25 dB |
| 0 0 0 0 1 0 | + 0.5 dB |
| ⋮ | ⋮ |
| 1 1 1 1 1 1 | + 15.75 dB |

+ 0.25 dB
(64 IN ALL)